# EUROPÄISCHE PATENTSCHRIFT

(11) **EP 2 024 982 B1**
(45) Veröffentlichungstag und Bekanntmachung des Hinweises auf die Patenterteilung: **03.10.2012**
(21) Anmeldenummer: 07764564.6
(22) Anmeldetag: 02.06.2007
(51) Int. Cl.: H01H 3/02, H03K 17/96

(54) **BEDIENELEMENT FÜR EIN KRAFTFAHRZEUG**
OPERATIONAL CONTROL FOR A VEHICLE
ÉLÉMENT DE COMMANDE POUR UN VÉHICULE AUTOMOBILE

(30) Priorität: 07.06.2006 DE 102006026826; 31.05.2007 DE 102007025564
(43) Veröffentlichungstag der Anmeldung: 18.02.2009
(73) Patentinhaber: PREH GmbH, 97616 Bad Neustadt (DE)
(72) Erfinder: ERDLOFF, Dirk, 97618 Hohenroth (DE); GESSNER, Volker, 97616 Salz (DE); SCHUBERTH, Stefan, 97616 Bad Neustadt a.d. Saale (DE); KRAUS, Peter, 97493 Bergreinfeld (DE)
(74) Vertreter: Bauer, Wulf
(86) Internationale Anmeldenummer: PCT/EP2007/004911
(87) Internationale Veröffentlichungsnummer: WO 2007/140956

(56) Entgegenhaltungen:
- EP-A- 1 635 366
- EP-A- 1 758 135
- EP-A- 1 760 738
- WO-A-2006/128409
- US-A- 5 889 507

## Beschreibung

Die Erfindung betrifft ein Bedienelement für ein Kraftfahrzeug mit einem Gehäuse und mindestens einer bewegbar in dem Gehäuse aufgenommenen Taste, insbesondere einer Hubtaste.

In Kraftfahrzeugen stehen dem Bediener oft eine Vielzahl von Auswahltasten zur Bedienung von Steuergeräten und Auswahlmenüs zur Verfügung. Beispielsweise in dem Fall, in dem in einem Bedienelement einer Taste unterschiedliche Funktionen zuweisbar sind, ist es für den Bediener von Vorteil, wenn er vor der Betätigung der Taste eine Rückmeldung erhält, welche Funktion dieser Taste zugeordnet ist. Ein Vorteil würde sich auch dadurch ergeben, dass dem Bediener die der Taste zugeordnete Funktion visuell dargestellt oder akustisch mitgeteilt wird. Hierdurch wird der Bediener bei der Auswahl der Tasten nicht von der Führung des Fahrzeuges abgelenkt. Eine derartige Rückmeldung von Tasten vor der Bedienung ist nicht bekannt.

Aus der DE 696 02 161 T2 ist eine kapazitive Taste bekannt, bei der die Bedienung eines Steuergerätes durch eine beispielsweise Glaskeramikplatte hindurch bedienbar ist. In diesem Fall erfährt der Bediener aber auch erst nach der Auswahl eine visuelle oder akustische Rückmeldung über die ausgewählte Steuerfunktion.

EP 1635 366 A offenbart ein Bedienelement mit einer Taste gemäβß dem Oberbegriff des Anspruchs 1.

Die Aufgabe der Erfindung ist es, ein Bedienelement bereitzustellen, bei dem der Bediener bei einer Annäherung an die Taste ein visuelles oder akustisches Signal erfährt, so dass vor der Auswahl der Tastfunktion dem Bediener die Funktion mitgeteilt wird. Darüber hinaus stellt sich die Aufgabe, eine Lösung zu entwickeln, welche konstruktiv einfach ist, leicht automatisierbar und wirtschaftlich günstig herzustellen ist.

Die Aufgabe der Erfindung wird dadurch gelöst, dass eine Taste in einem Bediengerät im Inneren zumindest bereichsweise hohl ausgeführt ist und im Inneren der Taste eine Elektrode eines Kondensators angeordnet ist, so dass bei einer Annäherung eines Bedieners an die Taste eine Kapazitätsänderung mittels einer nachgeschalteten Elektronik erfassbar ist. Durch den erfindungsgemäßen Aufbau der Taste, die vorzugsweise eine Hubtaste mit einem Hub von ca. 2 mm ist, ist nun die Möglichkeit geschaffen, durch konstruktiv einfache Mittel ein Annähern an die Taste elektronisch zu erfassen und mit einer nachgeschalteten Auswerteelektronik dem Bediener eine visuelle und/oder akustische Rückmeldung zu vermitteln, so dass dem Bediener ohne eine Betätigung der Taste die der Taste zugeordnete Funktion vermittelbar ist. Anzumerken bleibt hier, dass in Abhängigkeit von der Fläche des Sensorelementes auch größere Abstände zwischen Taste und Sensorblech realisierbar sind. In den Unteransprüchen sind vorteilhafte Ausgestaltungsvarianten der Erfindung beschrieben. Als besonders vorteilhaft hat es sich herausgestellt, eine erste Elektrode der Kapazität fest und unmittelbar unterhalb der Taste im Bedienelement zu befestigen und für die zweite Elektrode der Kapazität die Karosserie des Fahrzeuges, in dem das Bedienelement verbaut ist, einzusetzen. Nähert sich nun der im Fahrzeug befindliche Bediener der Taste, so ändert sich die Kapazität zwischen den Elektroden, so dass die nachgeschaltete Elektronik diese Annäherung erfasst. Dem Bediener kann entweder in einem Display, einem Head-Up-Display, als Leuchtmittel und/oder akustisch die Funktion der Taste angezeigt werden. Von Vorteil ist eine derartige berührungssensitive Taste beispielsweise in den Fällen, in denen eine erfindungsgemäße Taste beispielsweise neben einem Display angeordnet ist, so dass die Funktion der Taste visuell im Display beispielsweise vergrößert darstellbar ist. Die Bedienung wird durch die Einbindung eines erfindungsgemäßen Tastelementes wesentlich erleichtert.

In einer vorteilhaften Ausführungsform der Erfindung, ist unterhalb der Hubtaste ein Blechteil als erste Elektrode der Kapazität fest in einem Bediengerät oder Bedienelement des Kraftfahrzeugs angeordnet. Die Hub-Taste ist hierbei etwa zwei Millimeter über dem Blechteil angeordnet und gegen eine Schaltmatte federnd bewegbar. Das Blechteil ist mittels einer Kontaktpille unmittelbar durch die Kontaktmatte hindurch mit der Leiterplatte des Bedienelementes elektrisch verbunden. Sind in dem Bedienelement zusätzlich metallische Oberflächen, beispielsweise als Zierchromleisten oder Chromblenden, angebracht, so besteht die Gefahr, dass durch elektrische Entladungen, beispielsweise durch elektrostatische Aufladungen des Bedieners, auf das Bediengerät und insbesondere auf die metallisierten Oberflächen gelangen, so könnten einerseits die kapazitiven Elemente beeinflusst oder elektrische Bauteile auf der Leiterplatte beschädigt werden. Die Erfindung sieht hierbei vor, die metallisierten Oberflächen ebenfalls durch die Kontaktmatte hindurch mittels Kontaktpillen elektrisch mit der Masse des Kraftfahrzeuges zu verbinden, um so die elektrostatischen Ladungen gegen die Fahrzeugmasse abzuführen.

Nachfolgend wird die Erfindung anhand eines Ausführungsbeispiels näher erläutert.

Es zeigen:
- Figur 1: eine dreidimensionale Ansicht auf ein erfindungsgemäß ausgeführtes Bedienelement, das teilweise in einer Explosionsdarstellung wiedergegeben ist,
- Figur 2: eine ebenfalls dreidimensionale Ansicht auf ein erfindungsgemäßes Bedienelement in einer vergrößerten Darstellung und in einer weiter zerlegten Form,
- Figur 3: einen Schnitt durch ein erfindungsgemäß aufgebautes Bedienelement aus Richtung des Pfeils **III** aus Figur 1 und
- Figur 4: eine weitere dreidimensionale Ansicht eines erfindungsgemäßen Bedienelementes.

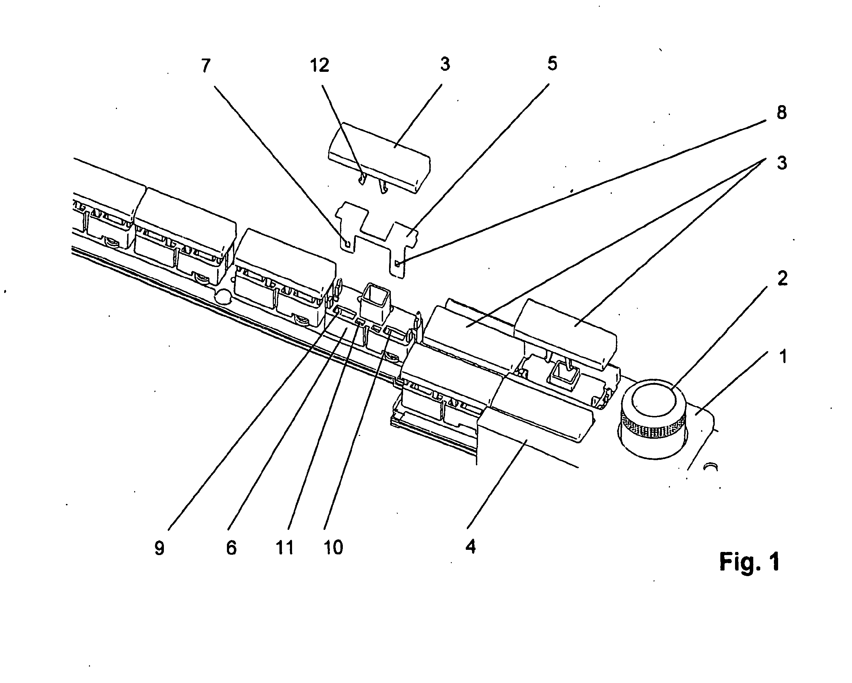

In der Figur 1 ist ein Bedienelement 1, wie beispielsweise ein Radiobedienteil, ein Klimabedienteil, ein Bedienteil für ein Navigationsgerät et cetera in einer dreidimensionalen Darstellung wiedergegeben. Das Bedienelement 1 weist einen Drehsteller 2 sowie eine Vielzahl von Hubtasten 3 auf, wobei die Hubtasten 3 in Richtung einer Blende 4 des Bedienelementes 1, in die Blende 4 hinein, bewegbar im Bedienelement aufgenommen sind. Wie etwa in der Mitte der Figur 1 als Explosionsdarstellung wiedergegeben, ist unterhalb der Taste 3 ein Blechteil 5 im Tastenunterteil 6 ortsfest befestigt. Die Taste 3 bewegt sich über das Blechteil 5 hinweg. Hierbei werden an das Blechteil 5 angeformte Verlängerungen 7, 8 in schlitzförmige Führungen 9, 10 des Tastenunterteils 6 hineingeführt und im Tastenunterteil 6 fixiert. Unterhalb der Taste 3 bildet das Blechteil 5 in dieser Ausführungsform eine im Wesentlichen U-förmige Form, so dass bei einem Bedienen der Taste 3 jederzeit zumindest ein Teil des Blechteils 5 überdeckt ist und gleichzeitig einen Bereich zur Ausleuchtung, wie beispielsweise einem Nachtdesign, eines Symbols auf der Taste freilässt. Vorstellbar ist natürlich auch, dass das Blechteil 5 vollflächig unterhalb der Taste 3 angeordnet ist. Die Taste 3 wird in Öffnungen 11 mittels Schnapphaken 12 im Tastenunterteil 6 bewegbar gehalten. Zur Übersichtlichkeit wurden lediglich eine Öffnung 11 und ein Schnapphaken 12 mit Bezugszeichen versehen.

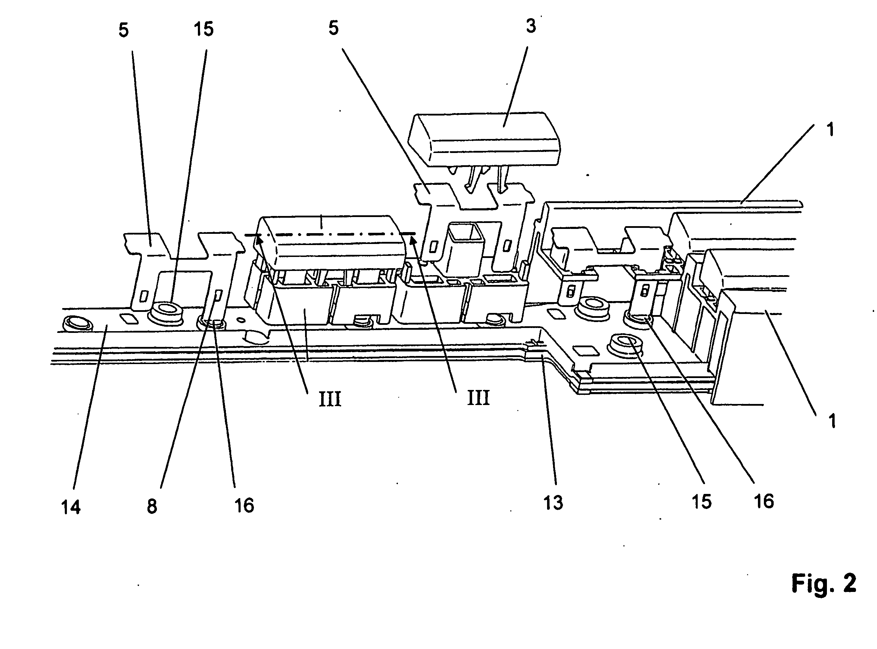

Wie aus der Figur 2 ersichtlich, wobei die Figur 2 die Position der Blechteile 5 im Bedienelement 1 detailliert darstellt. Auf einer Leiterplatte 13 liegt eine Kontaktmatte 14 auf. Die Kontaktelemente 15 dienen dabei zur Auswahl der mittels der Tasten 3 auswählbaren Funktionen. Die Kontaktelemente der Kontaktmatte 14 dienen dabei gleichzeitig als Gegenkraft zur Positionierung der Hubtasten 3 in ihrer Ausgangsposition. Wesentlich ist jedoch die Anordnung des Blechteils 5, wobei die Verlängerung 8 auf eine Kontaktpille 16 trifft, beziehungsweise an der Kontaktstelle 16 anliegt und so den elektrischen Kontakt durch die Kontaktmatte 14 hindurch zur Leiterplatte 13 vornimmt, wobei die Verwendung einer Kontaktpille eine bevorzugte Ausführungsform wieder gibt. Über die Leiterplatte 13 erfolgt auch die elektrische Kontaktierung zur zweiten Elektrode der Kapazität sowie zur Auswerteelektronik.

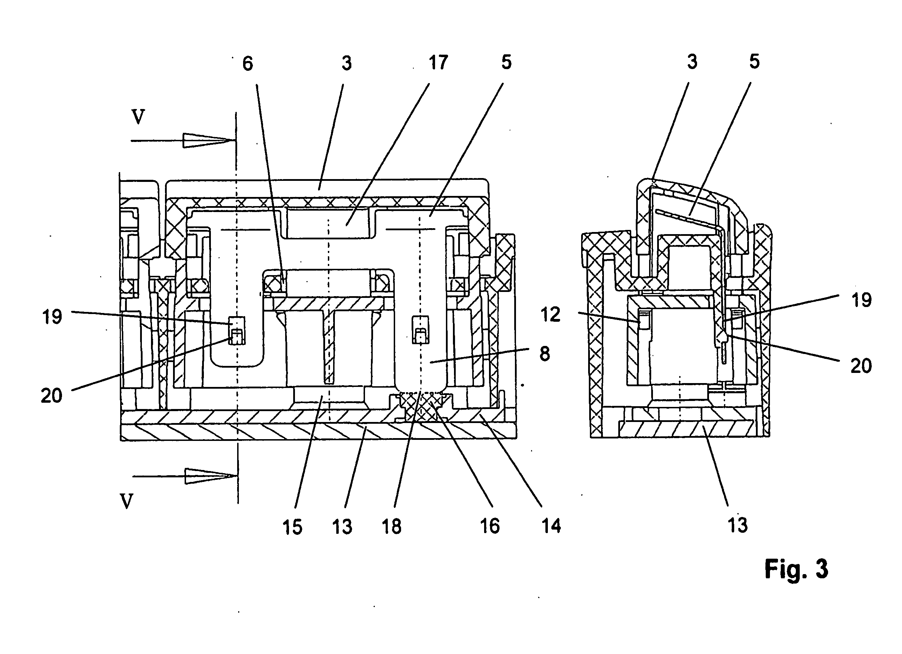

In der Figur 3 ist ein Schnitt durch ein erfindungsgemäß aufgebautes Bedienelement 1 entlang der Linie III-III aus Figur 2 dargestellt. Die Figur 3 zeigt die Tastenkappe 3 in ihrer Ausgangsposition, in der der Kontaktdom 15 der Schaltmatte 14 die Taste 3 in ihrer Ausgangsposition hält. Die Kraftübertragung von Taste 3 zu Kontaktung 15 erfolgt über ein bewegbar im Tastenunterteil aufgenommenes Mittelteil 17. Das Mittelteil 17 liegt gegen Anschläge im Tastenunterteil 6 an. An die Verlängerung 8, die sich bis zur Kontaktpille 16 erstreckt, ist eine Spitze 18 angeformt. Hierbei bildet die Spitze 18 lediglich eine geometrische Ausführungsform, wobei die auszuwählende geometrische Form dem einzustellenden Übergangswiderstand auf die Kontaktpille 16 entspricht. Die Spitze 18 dient hierbei zur besseren Kontaktierung mit der Kontaktpille 16. Die Kontaktpille 16 besteht im Wesentlichen aus einer Silikon-Kautschuk-Kohlenstoff-Mischung und besitzt einen niederohmigen Widerstand. Hierbei ist die Kontaktpille 16 ebenfalls leicht elastisch ausgeführt. Mittels der Kontaktpille 16 wird der elektrische Kontakt zwischen dem Blechteil 5 und der Leiterplatte 13 hergestellt. Wie der Figur 3 und hier insbesondere der linken Abbildung zu entnehmen, reicht die Kontaktpille 16 von der Verlängerung 8 des Blechteils 5 durch die Kontaktmatte 14 hindurch bis zur Leiterplatte 13, wobei die Kontaktpille 16 in der Kontaktmatte 14 gehalten ist. Das Blechteil 5 wird mittels Öffnungen 19 und Rasthaken 20 im Tastenunterteil 6 gehalten.

Die rechte Ansicht in der Figur 3 zeigt einen Schnitt durch das erfindungsgemäße Bedienelement 1 entlang der Linie V-V. Zu erkennen ist in der Seitenansicht der Hub H der Taste 3 oberhalb des Blechteils 5. Der Hub liegt üblicherweise in einem Bereich von 1,5 bis 2 mm.

Da das Blechteil 5 fest im Tastenunterteil 6 aufgenommen ist, bewegt sich die Taste 3 relativ zum Blechteil und drückt hierbei das Mittelteil 17 gegen den Kontaktdom 15, so dass mittels der Taste 3 der Kontakt auf der Leiterplatte 13 schließbar ist.

Das Blechteil 5 bildet die erste Elektrode der Kapazität, die über die Kontaktpille mit der Leiterplatte 13 verbunden ist. Anzumerken bleibt hier, dass es erfindungsgemäß ebenfalls vorstellbar ist, die Elektrode aus einem alternativen elektrisch leitfähigen Werkstoff auszubilden, beispielsweise aus einem metallischen Kunststoffbauteil, hierbei sind auch lediglich partiell metallisierte Formteile vorstellbar. Über die Leiterplatte ist die Fahrzeugkarosserie als zweite Elektrode der Kapazität mit dem Blechteil 5 verschaltet. Der Bediener, der sich beispielsweise mit einem Finger der Taste 3 nähert, ändert hierbei die Kapazität zwischen den beiden Elektroden, dem Blechteil 5 und der Fahrzeugkarosserie, so dass eine Auswertung möglich wird und ein visuelles oder akustisches Signal für den Bediener bereit gestellt werden kann. Zur Erhöhung der Auswertestabilität des Kondensators ist der Kondensator in einem Spule-Kondensator-Schwingkreis eingebunden. Um das Ansprechverhalten der Kapazität zu erhöhen, wird erfindungsgemäß vorgeschlagen, einen zweiten Schwingkreis parallel zur ersten Spule-Kondensator-Einheit in die Elektronik einzubinden. Hierdurch ist das Ansprechverhalten leicht einstell- und justierbar. Darüber hinaus ist es erfindungsgemäß ebenfalls vorstellbar, die Lade- und Entladezeiten für die Auswertung zu verwenden. Weiterhin ist eine alternative Ausführung in der Weise vorstellbar, dass die Auswertung der Kapazitätsänderung über ein separates oder vorhandenes, mit einer Auswerteelektronik ausgestattetes IC erfolgt, welches die Auswertung vornimmt.

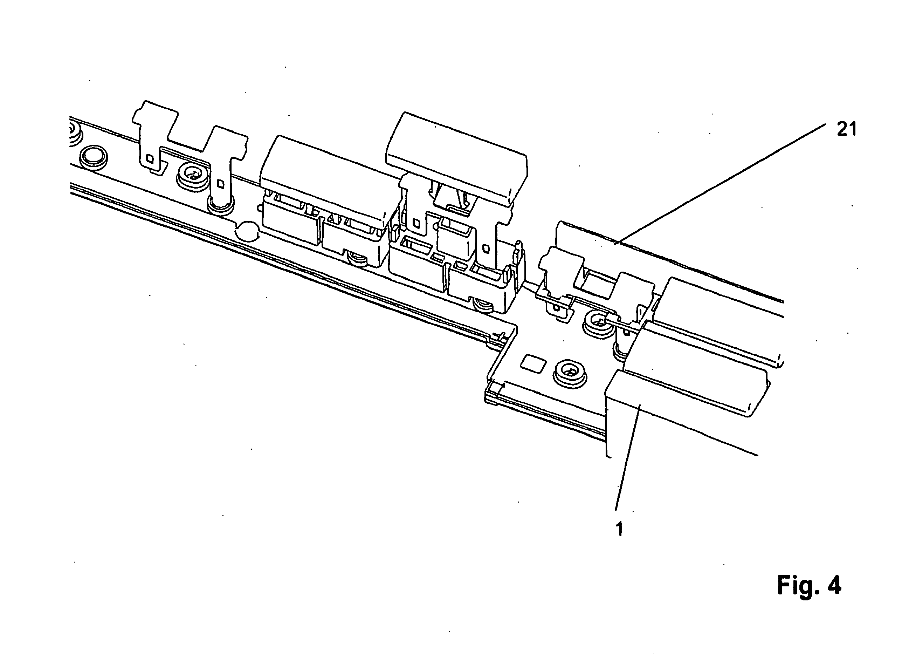

Zur Darstellung einer weiteren vorteilhaften Ausgestaltung ist es vorstellbar, ein Teil 21 der Blende 4 des Bedienelementes 1 mit einer metallischen Oberflächenbeschichtung zu versehen, wie in Figur 4 dargestellt. Hierbei wird der metallisierte Bereich 21 ebenfalls durch eine Kontaktierung der Oberflächenbeschichtung 21 mit einer Kontaktpille durch die Kontaktmatte 14 hindurch auf die Leiterplatte 13 mit der Fahrzeugmasse verbunden. Hierdurch können elektrische beziehungsweise elektrostatische Entladungen auf die Fahrzeugmasse abgeleitet werden. Dies dient insbesondere einem Schutz der elektronischen Bauteile auf der Leiterplatte 13 des Bedienelementes 1.

## Patentansprüche

1. Bedienelement für ein Kraftfahrzeug mit einem Gehäuse (1) und mindestens einer bewegbar in dem Gehäuse (1) aufgenommenen Taste (3), insbesondere einer Hubtaste (3), wobei die Taste (3) im Inneren zumindest bereichsweise hohl ausgeführt ist und im Inneren der Taste (3) eine Elektrode (5) eines Kondensators angeordnet ist, so dass bei einer Annäherung eines Bedieners an die Taste (3) eine Kapazitätsänderung mittels einer nachgeschalteten Elektronik erfassbar ist, **dadurch gekennzeichnet, dass** die Taste (3) gegen die Federkraft einer Kontaktmatte (14) bewegbar ist, wobei die Taste (3) mittels der Kontaktmatte (14) in einer Ausgangsposition gehalten ist, dass die Elektrode aus einem Blechteil (5) oder aus einem metallisierten Kunststoffteil gebildet ist und sich bereichsweise oder über die gesamte oberflächliche Ausdehnung der Taste (3) erstreckt und im Gehäuse (1) fixiert ist und über eine Kontaktpille (16) durch die Kontaktmatte (14) hindurch mit einer Leiterplatte (13) des Bedienteils (1) elektrisch kontaktiert ist und, dass die Taste (3) mit mindestens einem weiteren Kontakt (15) der Kontaktmatte (14) zusammenwirkt.

2. Bedienelement nach Anspruch 1, **dadurch gekennzeichnet, dass** an einem Ende (8) des Blechteils (5), das mit der Kontaktpille (16) kontaktiert ist, eine Spitze (18) angeformt ist, so dass eine höhere Kontaktsicherheit gewährleistet ist.

3. Bedienelement nach einem der vorhergehenden Ansprüche, **dadurch gekennzeichnet, dass** die Taste (3) eine Hubtaste (3) ist und einen Hub (H) von ca. 2 mm ausführt.

4. Bedienelement nach einem der vorhergehenden Ansprüche, **dadurch gekennzeichnet, dass** eine zweite Elektrode des Kondensators von der Karosserie des Kraftfahrzeugs gebildet ist.

5. Bedienelement nach einem der vorhergehenden Ansprüche, **dadurch gekennzeichnet, dass** die Kapazitätsänderung mittels eines Schwingkreises, insbesondere eines Spule-Kondensator-Schwingkreises, auswertbar ist.

6. Bedienelement nach einem der vorhergehenden Ansprüche, **dadurch gekennzeichnet, dass** eine Ansprechempfindlichkeit der Kapazität mittels eines zweiten parallelen Schwingkreises einstellbar ist.

7. Bedienelement nach einem der vorhergehenden Ansprüche, **dadurch gekennzeichnet, dass** die Kapazitätsänderung mittels eines IC's, insbesondere auf Basis von Lade- und Entladezeiten der Kapazität, auswertbar ist.

8. Bedienelement nach einem der vorhergehenden Ansprüche, **dadurch gekennzeichnet, dass** das Gehäuse (1) neben den Tasten (3) mindestens eine zusätzliche metallisierte Oberfläche (21), insbesondere verchromte Oberfläche (21), aufweist, und die metallisierte Oberfläche (21) mit der Fahrzeugmasse verbunden ist, so dass elektrische Ladungen von der metallisierten Oberfläche (21) ableitbar sind.

9. Bedienelement nach einem der vorhergehenden Ansprüche, **dadurch gekennzeichnet, dass** die Kontaktpille (16) aus einem leitenden, niederohmigen Werkstoff, insbesondere einer Silikon-Kautschuk-Kohlenstoff-Mischung, gebildet ist.

10. Bedienelement nach einem der vorhergehenden Ansprüche, **dadurch gekennzeichnet, dass** die Auswerteelektronik mit einer Anzeige, einem Display, einem Leuchtmittel und/oder einem ein akustisches Signal generierenden Bauteil verbunden ist, so dass eine Annäherung eines Bedieners an die Taste visuell und/oder akustisch erfassbar ist.

## Claims

1. Operating element for a motor vehicle, comprising a housing (1) and at least one button (3), in particular a pushbutton (3), movably accommodated in the housing (1), wherein the button (3) is configured to be hollow at least in parts on the inside and an electrode (5) of a capacitor is disposed in the interior of the button (3), so that, in the event of a user approaching the button (3), a capacitance change is detectable by means of an electronics unit connected downstream, **characterised in that** the button (3) can be moved against the spring force of a contact mat (14), wherein the button (3) is held in an initial position by means of the contact mat (14), that the electrode is formed from a sheet-metal part (5) or a metallized plastic part and extends over some areas or over the entire surface extent of the button (3), and is fixed in the housing (1), and is contacted to a circuit board (13) of the operating part (1) through the contact mat (14) via a contact pill (16), and that the button (3) cooperates with at least one further contact (15) of the contact mat (14).

2. Operating element according to claim 1, **characterised in that** a tip (18) is moulded on at one end (8) of the sheet-metal part (5) contacted to the contact pill (16), so that a greater contact stability is ensured.

3. Operating element according to any one of the preceding claims, **characterised in that** the button (3) is a pushbutton (3) and carries out a stroke (H) of approx. 2 mm.

4. Operating element according to any one of the preceding claims, **characterised in that** a second electrode of the capacitor is formed by the body of the motor vehicle.

5. Operating element according to any one of the preceding claims, **characterised in that** the capacitance change can be evaluated by means of a resonant circuit, in particular a coil-capacitor resonant circuit.

6. Operating element according to any one of the preceding claims, **characterised in that** the response sensitivity of the capacitance can be adjusted by means of a second parallel resonant circuit.

7. Operating element according to any one of the preceding claims, **characterised in that** the capacitance change can be evaluated by means of an IC, in particular based on the charging and discharging times of the capacitance.

8. Operating element according to any one of the preceding claims, **characterised in that** the housing (1), in addition to the buttons (3), comprises at least one additional metallized surface (21), in particular chromium-plated surface (21), and the metallized surface (21) is connected to the vehicle mass, so that electrical charges can be drained off from the metallized surface (21).

9. Operating element according to any one of the preceding claims, **characterised in that** the contact pill (16) is formed from a conductive, low-resistance material, in particular a silicone rubber-carbon mixture.

10. Operating element according to any one of the preceding claims, **characterised in that** the electronic evaluation system is connected to an indicator, a display, a lamp and/or a component generating an acoustic signal, so that an approach of a user towards the button is visually and/or acoustically detectable.

## Revendications

1. Elément de commande pour un véhicule automobile, comprenant un boîtier (1) et au moins une touche (3) logée à déplacement dans ledit boîtier (1), en particulier une touche à course (3), ladite touche (3) étant réalisée creuse à l'intérieur, au moins par sections, et une électrode (5) d'un condensateur étant disposée dans l'intérieur de ladite touche (3) de sorte que, lorsqu'un opérateur s'approche de ladite touche (3), un changement de capacité peut être détecté au moyen d'une électronique montée en aval, **caractérisé par le fait que** ladite touche (3) peut être déplacée contre la force élastique d'un tapis de contact (14), ladite touche (3) étant maintenue dans une position de départ au moyen dudit tapis de contact (14), que ladite électrode est réalisée à partir d'une pièce en tôle (5) ou d'une pièce métallisée en matière plastique et s'étend par sections ou sur toute l'extension superficielle de ladite touche (3) et est fixée dans ledit boîtier (1) et est contactée électriquement, par une pilule de contact (16), à travers ledit tapis de contact (14), avec une plaque de circuit imprimé (13) de l'élément de commande (1) et que ladite touche (3) coopère avec au moins un autre contact (15) du tapis de contact (14).

2. Elément de commande selon la revendication 1, **caractérisé par le fait qu'**une pointe (18) est formée sur une extrémité (8) de ladite pièce en tôle (5), qui est mise en contact avec ladite pilule de contact (16), de sorte qu'une plus grande sécurité de contact est assurée.

3. Elément de commande selon l'une quelconque des revendications précédentes, **caractérisé par le fait que** ladite touche (3) est une touche à course (3) et effectue une course (H) de 2 mm à peu près.

4. Elément de commande selon l'une quelconque des revendications précédentes, **caractérisé par le fait qu'**une deuxième électrode du condensateur est formée par la carrosserie du véhicule automobile.

5. Elément de commande selon l'une quelconque des revendications précédentes, **caractérisé par le fait que** le changement de capacité peut être évalué au moyen d'un circuit oscillant, en particulier un circuit oscillant à bobine et condensateur.

6. Elément de commande selon l'une quelconque des revendications précédentes, **caractérisé par le fait qu'**une sensibilité de réponse de la capacité peut être réglée au moyen d'un deuxième circuit oscillant parallèle.

7. Elément de commande selon l'une quelconque des revendications précédentes, **caractérisé par le fait que** le changement de capacité peut être évalué au moyen d'un circuit intégré, en particulier sur la base de temps de charge et de décharge de la capacité.

8. Elément de commande selon l'une quelconque des revendications précédentes, **caractérisé par le fait que** ledit boîtier (1) présente, outre les touches (3), au moins une surface métallisée (21) supplémentaire, en particulier surface chromée (21), et que ladite surface métallisée (21) est reliée à la masse du véhicule de sorte que des charges électriques peuvent être déviées de ladite surface métallisée (21).

9. Elément de commande selon l'une quelconque des revendications précédentes, **caractérisé par le fait que** ladite pilule de contact (16) est réalisée dans un matériau conducteur à faible valeur ohmique, en particulier dans un mélange de silicone, de caoutchouc et de carbone.

10. Elément de commande selon l'une quelconque des revendications précédentes, **caractérisé par le fait que** l'électronique d'évaluation est connectée à un dispositif d'affichage, à un écran de visualisation, à un moyen lumineux et/ou à un composant générant un signal acoustique, de sorte que **le fait qu'**un opérateur s'approche de la touche peut être détecté de manière visuelle et/ou acoustique.
